# EUROPEAN PATENT SPECIFICATION

(11) **EP 2 419 215 B1**
(45) Date of publication and mention of the grant of the patent: **01.07.2015**
(21) Application number: 10764742.2
(22) Date of filing: 15.04.2010
(51) Int. Cl.: H01J 37/20, H01J 37/26, H01J 37/22, B25J 7/00

(54) **OPTICAL PROBING IN ELECTRON MICROSCOPES**
OPTISCHE SONDIERUNG IN ELEKTRONENMIKROSKOPEN
SONDAGE OPTIQUE DANS DES MICROSCOPES ÉLECTRONIQUES

(30) Priority: 15.04.2009 US 169442 P
(43) Date of publication of application: 22.02.2012
(73) Proprietor: FEI Company, Hillsboro, OR 97124 (US)
(72) Inventor: DANILOV, Andrey, S-431 39 Mölndal (SE); OLIN, Håkan, S-857 41 Sundsvall (SE); ANGENETE, Johan, S-412 52 Göteborg (SE)
(74) Representative: Bakker, Hendrik
(86) International application number: PCT/SE2010/050405
(87) International publication number: WO 2010/120238

(56) References cited:
- EP-A1- 1 953 791
- JP-A- 8 031 362
- JP-A- H0 831 361
- JP-A- H0 831 362
- JP-A- S61 104 551
- JP-A- 2009 123 477
- US-A1- 2002 166 976
- US-A1- 2002 166 976
- US-A1- 2008 210 869
- US-A1- 2010 102 248

## Description

### TECHNICAL FIELD

The present invention relates to an optical arrangement and in particular to an optical arrangement for use in electron microscopy applications.

### BACKGROUND OF THE INVENTION

Materials with electro-optical properties play an important role in e.g. telecommunication, electronics, sensors, signal systems etc. Their importance is expected to grow further in the future as they will play a central role in components for energy harvesting in photovoltaic systems as well as in light-emitting devices (LED), the latter becoming a very important application as conventional light bulbs are replaced by more energy-efficient and mercury-free lighting systems. These trends are also exemplified by the large investments currently being made in research and production facilities Today, the research activity around nanostructured materials (nano wires, nano tubes, nano particles, nano films) is intense, since the limited dimensions of these materials have proven to amplify or modify e.g. their electro-optical properties, which in turn enables new applications of such materials.

Efforts towards developing nanostructured materials are entirely dependent on suitable methods for characterization, and as the particular needs for such methods vary, it is necessary to develop flexible and modifiable technologies for their realization. One example of a method which has tremendous flexibility is transmission electron microscopy (TEM) which, together with its' auxiliary equipment plays a central role in the investigation of nanostructured materials.

Japanese patent application JPH08031361 discloses a heating device for an electron microscope, whereby a sample can be heated by a laser beam transmitted through an optical fiber and directed to the sample via an optical system installed on the sample holder.

Japanese patent application JPH08031362 discloses a means for measuring the temperature of a sample in a TEM. The sample temperature is measured by collecting light emitted from the sample using an optical system and an optical fiber.

EP 1 953 791 A1 discloses a TEM equipped with an optical microscope. The sample can be moved between a first position, used for TEM investigation, and a second position, in which it can be observed by the optical microscope. These two positions are located as some distance from each other. Therefore, this system does not allow for simultaneous structural and optical characterization of the sample.

US 2002/166976 A1 discloses a device and a method for separating micro-samples from a sample, and mounting it in a sample holder in order to perform TEM investigations on the micro-sample.

In order to characterise electro-optic materials on the nano scale, it may be useful, besides generating and detecting light, to be able to apply and measure electrical potentials and/or currents with a spatial resolution on the nano level. Moreover, a system for simultaneous high resolution imaging is needed, both to monitor the positioning of the probes onto the material and to study possible structural changes in the material during the course of the measurement. To achieve this, it is beneficial to combine several

methods, integrated with each other, for example scanning tunnelling microscopy (STM) for electrical probing, TEM for high resolution imaging, and optical systems for application and detection of light.

Technology is provided that allows three-dimensional positioning and manipulation with sub-Angstrom resolution with several millimeters range. The device used for the manipulation is small enough to be integrated into a sample holder e.g. for a transmission electron microscope (TEM) or scanning electron microscope (SEM).

Based on this technology various sample probing systems have been developed. One example of such a probing system is an STM for sample investigation in situ in a TEM. In this case, the manipulator is used to position a sharp needle very close to or in contact with the sample for electrical characterisation of the sample. Simultaneously, the TEM is used to monitor the approach and positioning of the probe onto individual nanostructures on the sample and to study and characterise any morphological, structural or compositional changes of the same structure during the experiment.

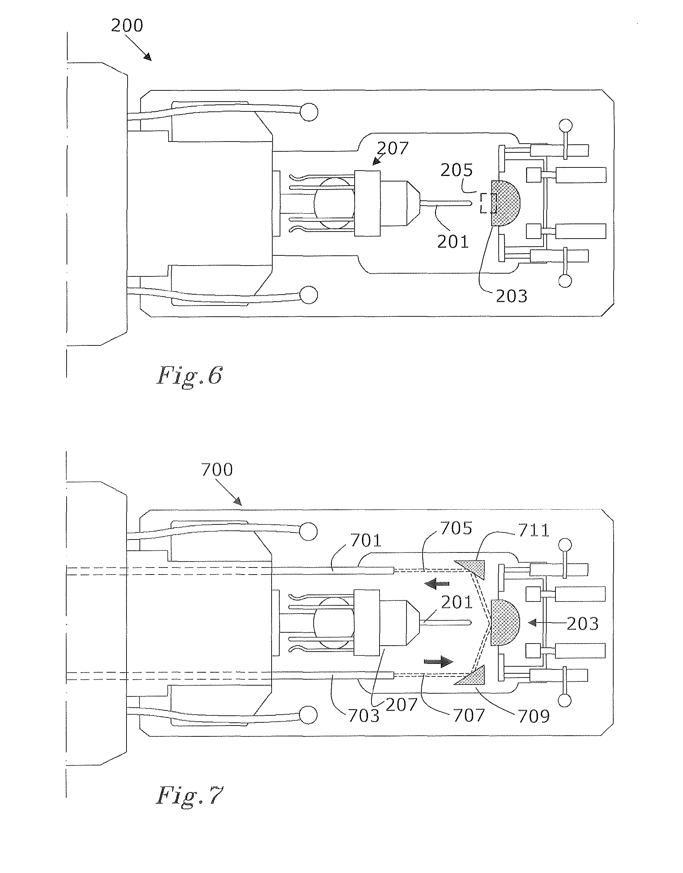

Such a known system is shown in Fig. 6 which shows a front end of a TEM sample holder 200 with an integrated STM probe 201. The sample 203 is positioned in the plane of the paper and simultaneously investigated by the STM tip 201 and imaged by the TEM within a designated imaging area 205. The STM tip 201 may be controlled with the use of a three dimensional manipulator 207. The electron beam of the TEM is oriented perpendicularly to the plane of the paper.

While the device of Fig. 6 is capable of providing electrical and mechanical characteristics while simultaneously providing structural or morphological changes, the device of Fig. 6 fails to provide optical characteristics of the sample. The characterization of optical properties or a sample is typically done separately given the space constraints of the sample holder 200.

### Summary of the Invention

The above mentioned problems of the prior art solutions are overcome by an electron microscope sample holder according to claim 1 and a respective method of characterising material properties according to claim 9.

Example embodiments of the present invention are directed towards solutions for measuring optical characteristics in an electron microscope. According to example embodiments the electron microscope may include optical measurement technology that may be configured to simultaneously provide optical measurements possibly in combination with scanning probe techniques.

Example embodiments may include an electron microscope sample holder arrangement for use in an electron microscope. The sample holder may be located so as to position the sample in a beam of an electron path of the electron microscope. A probe may be located so as to be positioned by a positioning unit in the beam of electron path. An optical input device may be located to receive light that has interacted with the sample and/or probe.

Example embodiments may further include an optical output device that may be arranged to direct light to an interaction area of the sample. The optical output device may be located through a positioning unit. Example embodiments may also include a light guiding device.

Example embodiments may also include a system for characterizing material properties of a sample in an electron microscope. The system may include a sample holder arrangement and a control device for controlling the sample holder arrangement and obtaining signals from the sample holder arrangement. The system may also include a light source that may be arranged to direct light to the sample holder arrangement, and a light detector that may receive light from the sample holder arrangement. The system may further include a computing device in communication with the control electronics that may be used for the analysis of signals from the sample holder arrangement and to control the sample holder arrangement.

Other example embodiments may include a method of characterizing material properties of a sample. The method may include positioning a sample in an electron microscope, and interacting a probe with the sample. The method may further include propagating light onto the sample/probe interaction area and detecting light from the interaction area simultaneously with obtaining images from the electron microscope. The method may also include obtaining signals from the light detector and obtaining images from the electron microscope, and relating obtained signals and images with each other in time.

Example embodiments may also include an electron microscope holder which may include a designated imaging area. The designated imaging area may be configured to position a sample in an electron beam of the electron microscope for structural characterization. The holder may also include an optical source configured to direct light on to the sample for optical characterization, where the structural and optical characterization may be simultaneous. The optical source may be, for example, an optical fibre. The optical beam path may also be inverted.

The holder may optionally include a second optical source.

The holder may also include a probe that may be configured to interact with the sample for simultaneous structural and/or mechanical characterization. The holder may further include a manipulator that may be configured to adjust a position of the optical source. The holder may also include an optical input configured to receive light that has interacted with the sample.

The number of measurement possibilities and material property analysis/characterization increases with the solution according to the example embodiments presented herein.

### BRIEF DESCRIPTION OF THE DRAWINGS

In the following the invention will be described in a non-limiting way and in more detail with reference to exemplary embodiments illustrated in the enclosed drawings, in which:
Fig. 1A illustrates schematically an EM sample holder according to the present invention;
Fig. 1B illustrates schematically a close up of the EM sample holder from Fig. 1;
Fig. 2 illustrates schematically an EM sample holder according to another embodiment of the present invention;
Fig. 3 illustrates schematically in a block diagram a method according to the present invention;
Fig. 4 illustrates schematically a measurement system according to the present invention;
Fig. 5 illustrates schematically a processing unit according to the present invention;
Fig. 6 illustrates schematically a TEM sample holder according to known technology;
Fig. 7 illustrates schematically an embodiment of the present invention;
Fig. 8 illustrates schematically an embodiment of the present invention;
Fig. 9 illustrates schematically an embodiment of the present invention;
Fig. 10 illustrates schematically an embodiment of the present invention; and
Fig. 11 illustrates schematically an embodiment of the present invention.

### DETAILED DESCRIPTION OF PREFERRED EMBODIMENTS

In the following description, for purposes of explanation and not limitation, specific details are set forth, such as particular components, elements, techniques, etc. in order to provide a thorough understanding of the present invention. However, it will be apparent to one skilled in the art that the present invention may be practiced in other embodiments that depart from these specific details. In other instances, detailed descriptions of well-known methods and elements are omitted so as not to obscure the description of the present invention.

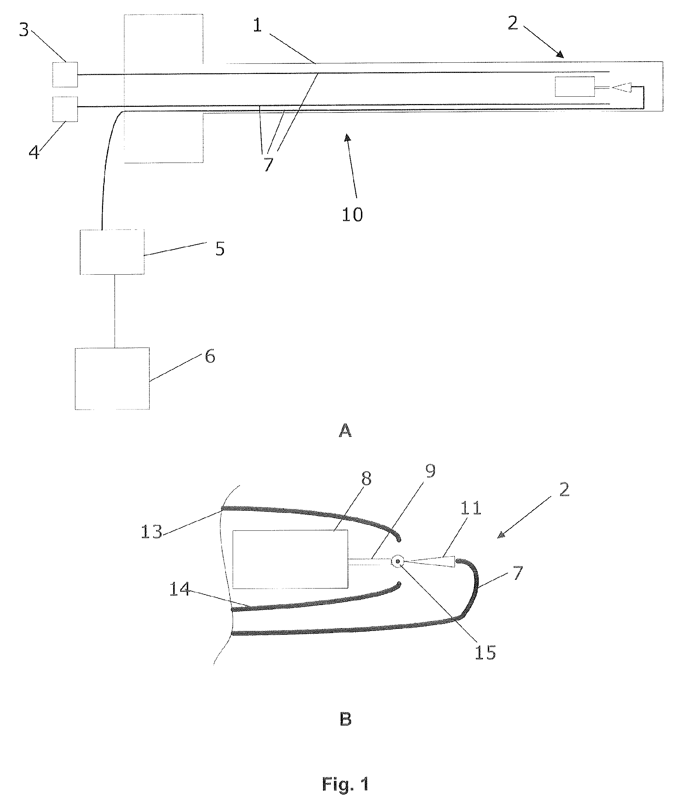

In Fig. 1A reference numeral 10 generally indicate an electron microscope (EM) sample holder arrangement according to example embodiments. The EM sample holder arrangement may include a holder structure 1 arranged to be inserted into an electron microscope, e.g. in a side-entry port, and made of suitable materials to reduce the risk of contamination of the EM and out gassing in the EM during operation, e.g. stainless steel, copper, brass, ceramic, appropriate plastic materials, and so on. This holder structure may hold a measurement unit 2 and optical fibers 7, which may be used for optical measurements on a sample in the measurement unit. Furthermore, light sources and/or detectors 3 and 4 may be connected to the optical fibers and a spectrometer 5 may be connected to an optical fiber for spectroscopic measurements. An analysis and control device 6 may be used for controlling the light sources and for obtaining signals from the spectrometer and/or optical detectors.

The electron microscope may be any type, e.g. a scanning electron microscope (SEM), a transmission electron microscope (TEM), a reflection electron microscope (REM), or a scanning transmission electron microscope (STEM).

The sample holder arrangement may be configured in such as a way as to fit into standard electron microscopes, for instance, for a TEM solution, the gap between magnetic lenses are small and the sample holder arrangement geometry will need to be thin in order to fit into this gap. Furthermore, the geometry of the sample holder arrangement is conformed to standard configurations in order to not disturb any analytical instrumentation attached to the electron microscope and allow for holder goniometer arrangements of the microscope.

In Fig. 1B the measurement unit 2 is shown in more detail. The measuring unit 2 may comprise a positioning unit 8 (manipulator) for controlling the position of a probe 9 in relation to a sample 11. Such a positioning unit may for instance comprise a piezo device operating with an inertial slider based technology or similar solution for micro or nano positioning of the probe. The positioning unit as shown later in this document enables positioning in three dimensions of the probe on a dimension scale of several millimeters with a resolution of sub-Angstrom. In Fig. 1B the electron beam position is indicated with reference numeral 15 and is indicated as being applied into or out of the paper; as may be seen, the sample and probe may be positioned in a path of the electron beam. The sample may comprise any type of sample of interest, for instance an indium tin oxide sample connected to an optical fiber 7. In vicinity of the interaction area between the probe and sample, one excitation fiber 13 may be located for directing light towards the sample/probe interface. Furthermore, a sensing optical fiber 14 may be located so as to receive reflected and/or transmitted light from the interaction area.

It should be appreciated that the sample and probe may be arranged in an opposite configuration as described, i.e. the sample may be positioned on the positioning unit and the probe positioned in a fixed position. It should be noted that the sample holder arrangement and measurement unit may be arranged with a suitable electron beam transmission path, e.g. using holes and/or electron transparent materials in the beam path. Optionally, the measurement unit and the sample holder arrangement may be arranged with a tilt mechanism. Furthermore, light noise reduction solutions may be used in order to reduce light emissions from noise sources (e.g. heat from the electron emission filament or ambient light from view port holes).

The positioning unit may comprise a ball unit connected to a piezo electric device and a probe holder may be clamped frictionally to the ball unit. By changing an applied voltage to the piezo electric device rapidly with appropriate signal characteristics, the probe holder position relative to the ball unit may be changed using an inertial slider effect, thereby changing the position of the probe relative to the sample. It should be appreciated that other electromechanical positioning technologies may be used depending on required resolution, noise characteristics, and full scale movement of the probe relative to the sample.

In one embodiment an excitation and/or detection optical fiber may be located as probe as will be discussed later in this document. In some example embodiments, optical excitation may not be provided directly by an optical fiber, but may be provided by other types of devices, such as for instance the electron beam in the electron microscope, so called e-cathode luminescence, electron emission from the probe using an electrical field emanating from the probe, contact current between probe and sample, strain induced in the sample, or using a SNOM based system. Example embodiments may further include a nanowire laser that may be used as light source which may be employed as a light probe.

It should be appreciated that various types of measurements may be performed using the example embodiments presented herein. For example, Raman spectroscopy measurements may be utilized in the optical EM sample holder. Cathodoluminescence may also be measured using example embodiments. Cathodoluminescence is photon emission when an electron beam from the microscope is hitting the sample. By scanning the sample or the focused beam laterally over the sample the optical signal or optical spectrum can be used for local analysis of the sample. This technique can be used for many different kinds of investigations including studies of direct bandgap semiconductors such as GaAs or mapping of defects in integrated circuits.

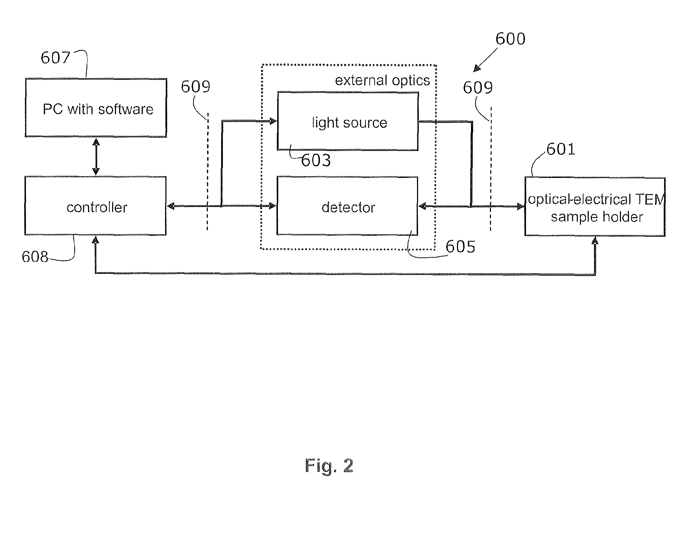

Example embodiments may also include a system 600 comprising an opto-STM-TEM sample holder 601, light sources 603, light detectors 605, and control systems including a computing device 607 and controller 608, is shown in Fig. 2. Fig. 2 is a schematic illustrating a measurement system for electro-optical nanomaterials. The light source 603 and detector modules 605 are standard components and may be connected via standard interfaces 609. The modular design enables optimisation for specific measurement purposes.

Another embodiment of an opto-STM-TEM holder 700 is shown in Fig. 7 which is a schematic of an opto-STM-TEM holder for the study of electro-optical materials, with double beam paths 705 and 707 arranged side-by-side. Here, the sample 203 may be illuminated and light from the sample detected by two separate beam paths 705 and 707. In this way it is possible to optimise the optical paths for illumination and detection separately. The optical paths may either comprise optical wave guides such as optical fibres 701 and 703 or it is possible to use freely propagating beams. It is possible to use either defocused beam paths or focussing them with the use of lens elements or focussing mirrors 709 and 711. The system may be equipped with active components for alignment and/or focussing. The SPM tip 201 may be positioned in the same way as before and may be used for electrical interaction with the sample simultaneously with optical and electron microscopy measurement. The experiment may be monitored simultaneously with the TEM.

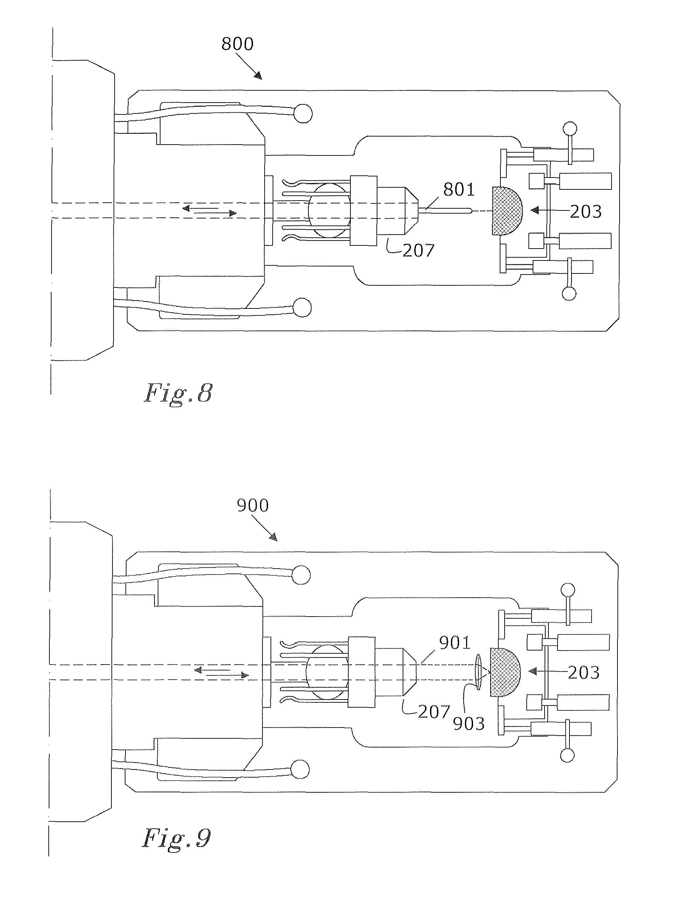

Another example embodiment is shown in Fig. 8. Fig. 8 illustrates a Schematic SNOM-TEM holder 800 where the tip 801 may be used for electrical probing, STM imaging, and SNOM investigation of the sample material 201. The STM tip 801 may comprise a capillary (conductive or metal-coated) with a very sharp end, e.g. less than 100 nm. An optical beam guide 803 may lead light through the centre of the nano-manipulator 207 into the capillary and the nano-manipulator 207 may be used for positioning the capillary relative to the sample. With this arrangement, the system may be used for scanning near field optical microscopy, SNOM, in which the resolution of the system may overcome the optical diffraction limit. The positioning of the capillary may be monitored by the TEM system. When operating at small distances between the capillary and the sample 203, the current, either tunnelling current or field emission current may be used for complementary measurement and control of the distance between the sample 203 and the tip 803.

In another example embodiment, illustrated in Fig. 9, the STM tip 901 may comprise an optical fibre 901 with a focussing element 903 (objective lens). The lens 903 may be positioned very close to the sample 203 and be used to illuminate the sample and/or to collect light from the sample. The optical beam guide, or fibre 901, leads light through the centre of the nano-manipulator 207, onto which the optical guide and the focussing element is attached. The focussing element 903 may be used as an objective lens, and the nano-manipulator 207 may be used to position the lens close to the sample 203. In this way, light from the sample can be collected over a large solid angle, which increases the collection efficiency. This system may be used to collect emitted light from the sample, for example as a cathode-luminescence (CL) system, where the light is generated by the interaction between the electron beam and the sample.

The embodiments discussed above involving an optical sensor arrangement may be utilized in combination with a number of different scanning probe microscopy applications, such as, but not limited to:
1. SPotM (Scanning Tunneling Potentiometry Microscopy)
2. SCM (Scanning Capacitance Microscopy)
3. SSRM (Scanning Spreading Resistance Microscopy)
4. AFM (Atomic Force Microscopy)
5. MFM (Magnetic Force Microscopy)
6. SFM (Scanning Force Microscopy)
7. SNOM (Scanning Near-Field Optical Microscopy, also known as NSOM)

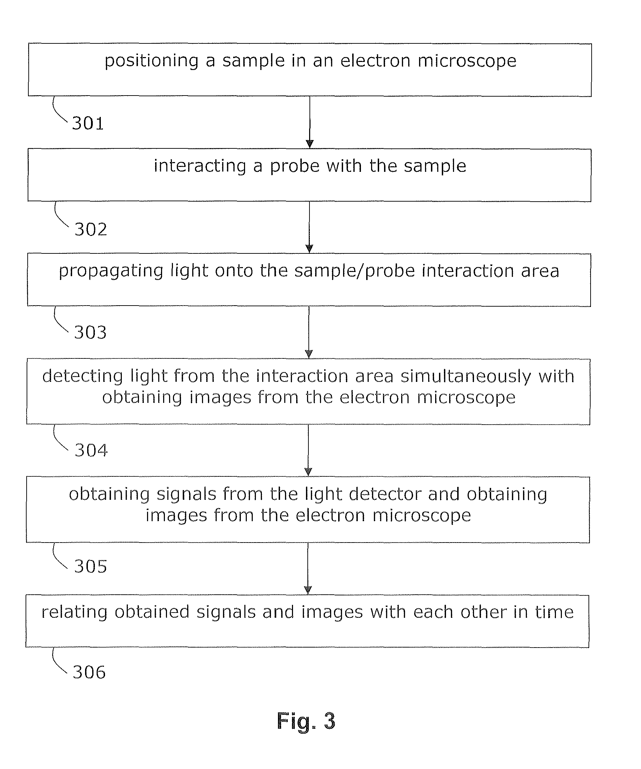

Fig. 3 is a flow diagram illustrating example steps that may be employed in optical characterization, according to example embodiments. An example method of characterizing material properties of a sample, may include the steps of:
301. positioning a sample in an electron microscope;
302. interacting a probe with the sample;
303. propagating light onto the sample/probe interaction area;
304. detecting light from the interaction area simultaneously with obtaining images from the electron microscope;
305. obtaining signals from the light detector and obtaining images from the electron microscope; and
306. relating obtained signals and images with each other in time.

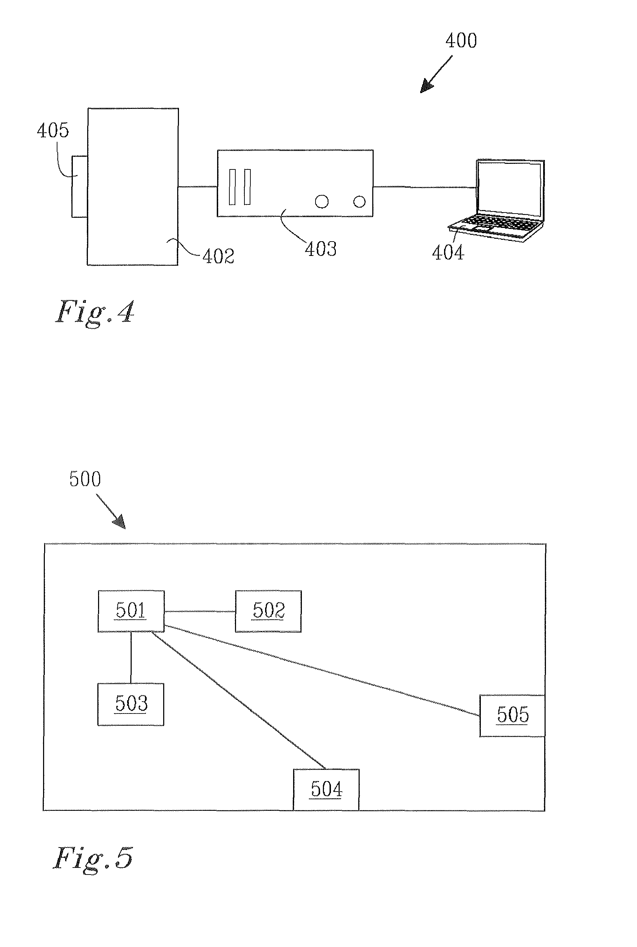

Fig. 4 shows a measurement system 400 according to example embodiments, where a measurement chamber 402, e.g. transmission electron microscope chamber, with a sample receiving port 405 may be connected to a processing and control and/or analyzing device 403 (or analyzing device 6 of Fig. 2), which in turn may be connected to a computational device 404 for analysis and storage/display of measured data. The detecting device as described earlier may be situated in the chamber 402 together with optional pre processing electronics that may be located directly on the sample holder or in the electrical path between the sample holder and processing device 403. Other components may be of interest depending on application, for instance if vacuum is needed in the chamber 402, vacuum generating and controlling equipment may be present as understood by the person skilled in the art.

Fig. 5 shows a detection processing and analyzing device 500 (similar to devices 6 and 403 of Figs. 2 and 4, respectively) according to example embodiments. The processing device 500 may comprise at least one processing unit 501, at least one memory 502, and optionally a user interface 503 for user interaction. Furthermore, the processing device 500 may comprise a measurement interface 504 and a communication interface 505. The measurement interface may connect the processing device to the detector in the chamber 402 and the communication interface may communicate measurement data to the computational unit 404. The communication interface may comprise for instance but not limited to an Ethernet link, a serial link, a parallel link, a VXI link and such as understood by a person skilled in the art. The processing unit may execute instructions sets (hardware or software based). The processing unit may for instance comprise a microprocessor, a digital signal processor, an FPGA (field programmable gate array), an ASIC (application specific integrated circuit), or similar devices. The memory 502 may comprise any suitable memory type of volatile and/or non-volatile type such as RAM, DRAM, ROM, EEPROM, hard disk, Flash, and so on. The processing device may be arranged to control the measurement by applying signals indicative of displacement of the detecting tip and to receive signals indicative of the measured signal from the detected electron beam. The processing device may receive signals for control of the detecting tip from the computational device 404. Furthermore, the processing device may also obtain signals from the optical detector and control a light source in accordance with measurement setup. The computational unit 404 may comprise software instructions executed to control the measurement devices, obtain signal for real time and/or post analysis, and interaction with a user.

The optical detector may be used for detecting the temperature of the sample, for example, by measuring the black body radiation, thus providing a temperature sensor to the measurement setup. This is a useful application because in many electrical conducting samples of nanometer dimensions such as carbon nanotubes, nanowires, point contacts, or other conductors, the critical current density before failure is remarkably high. This high current leads to Joule heating of the conductor, and due to the small volume a large increase in the temperature. However, the temperatures of such small objects are hard to measure using standard ways, but with this technique it is possible to obtain a black body spectrum from such small objects and thus get the temperature. The temperature is also useful in other situations such as, but not limited to, field emission, under mechanical pressure (using an AFM or indenter), during friction measurements (using an AFM), and in situ chemical reactions.

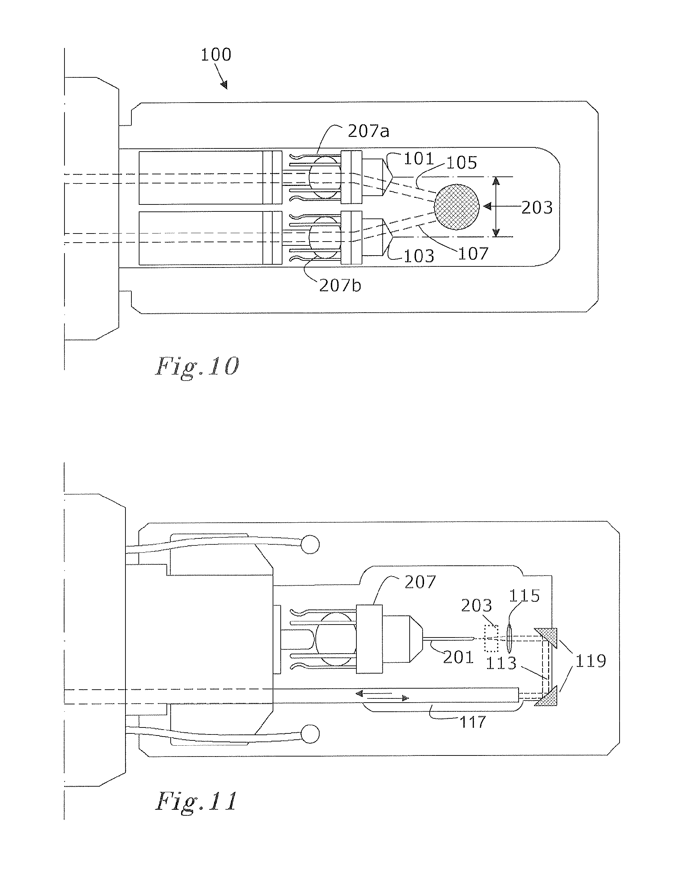

Fig. 10 shows an alternative embodiment, where a holder 100 with two manipulators 207a and 207b are each used to direct a light channel (e.g. an optical fiber 105 and 107, respectively, transmitting light from a light source) towards the sample interaction area 203.

Fig. 11 shows yet another alternative embodiment, with a holder 111 including an optical beam path 113 which may be "inverted". The sample 203 may be mounted on the probe tip 201, which in turn may be in connection with the manipulator 207. The light source 113 may be directed towards the sample 203, optionally with a lens 115 for focusing or defocusing the light. The light may be transmitted using an optical fiber 117 directly or as shown in Fig. 11 using one or more mirrors 119. Preferably, if an optical fiber is used directly it is of a kind that may be bent sharply without breaking or reducing the transmission effectiveness. Furthermore, mirrors used may be mounted on the frame of the microscope sample holder or incorporated into the frame (this is applicable to any embodiment of the invention)

It should be appreciated that the optical techniques discussed in this document are not limited to the visible part of the spectrum but other wavelengths may be utilized, e.g. ultraviolet, infrared spectrum, or x-ray parts.

It should be noted that the word "comprising" does not exclude the presence of other elements or steps than those listed and the words "a" or "an" preceding an element do not exclude the presence of a plurality of such elements. It should further be noted that any reference signs do not limit the scope of the claims, and that several "means", "units" or "devices" may be represented by the same item of hardware. It should be noted that the scales shown in the Figs are only shown as examples and that other scaling may be used depending on type and make of electron microscope.

The above mentioned and described embodiments are only given as examples and should not be limiting to the present invention. Other solutions, uses, objectives, and functions within the scope of the invention as claimed in the below described patent claims should be apparent for the person skilled in the art.

## Claims

1. An electron microscope sample holder **(601)** comprising:
a designated imaging area **(205)** configured to position a sample **(203)** in an electron beam of an electron microscope for structural characterization;
**characterized by**
an optical source **(703**, **801**, **901**, **105**, **107**, **113**, **117)** configured to direct light on to the sample **(203)** for optical characterization,
a manipulator **(207)** configured to control a position of the optical source **(801**, **901**, **105**, **107)** in relation to the sample **(203)**, and
an optical input **(701**, **801**, **901**, **101**, **103**, **117)** configured to receive light that has interacted with the sample (203),
wherein the electron microscope sample holder is configured to provide for simultaneous structural and optical characterisation of the sample.

2. The holder of Claim 1 further comprising a probe **(201**, **801**, **901)** configured to interact with the sample **(203)** for simultaneous structural and/or mechanical characterization.

3. The holder of Claim 1 or 2 wherein the optical source **(703**, **117)** is an optical fibre.

4. The holder of any one of Claims 1 to 3 wherein the manipulator **(207)** is configured to adjust the position of the optical source **(801**, **901**, **105**, **107)**.

5. The holder of any one of Claims 1 to 3 wherein the manipulator **(207)** is configured to adjust the position of the sample **(203)**.

6. The holder of any one of Claims 1 to 5 further comprising a second optical source **(105**, **107)**.

7. The holder of any one of Claims 1 to 5 adapted such that an optical beam path is inverted **(113)** such that light which has interacted with the sample is directed along the same optical beam path but in opposite direction as light directed to the sample.

8. A system **(600)** for characterizing material properties of a sample **(203)** in an electron microscope, comprising:
a sample holder **(601)** arrangement according to any one of the previous Claims;
a control device **(608)** for controlling the sample holder **(601)** and obtaining measurement signals from the sample holder **(601)**;
a light source **(603)** arranged to direct light to the sample holder **(601)**, the light source (603) being connected to the optical source;
a light detector **(605)** receiving light from the sample holder **(601)**, the light detector (605) being connected to the optical input **(701**, **801**, **901**, **101**, **103**, **117)**; and
a computing device **(607)** in communication with the control device configured to analyze signals from the sample holder **(601)** and further configured to provide instructions to the control device.

9. A method of characterizing material properties of a sample **(203)**, the method comprising:
providing an electron microscope sample holder (601, 700, 800, 900) according to claim 1,
positioning a sample **(203)** in a designated imaging area (205) of the electron microscope sample holder and in an electron beam of an electron microscope for structural characterisation; ¶
propagating light from an optical source **(703**, **801**, **901**, **105**, **107**, **113**, **117)** comprised in the electron microscope sample holder onto the sample (203) for optical characterisation;
on the electron microscope sample holder controlling with a manipulator (207) a position of the optical source **(801**, **901**, **105**, **107)** in relation to the sample **(203)**,
detecting light at an optical input (701, 801, 901, 101, 103, 117) on the electron microscope sample holder upon interaction with the sample **(203)**; and
simultaneously obtaining images with the electron microscope.

10. The method of Claim 9 further comprising interacting a probe **(201**, **801**, **901)** with the sample **(203)** and obtaining an interaction measurement.

11. The method of Claim 10 further comprising relating the detected light with the images obtained with the electron microscope and interaction measurement with each other in time.

## Patentansprüche

1. Elektronenmikroskop-Probenhalter (601) mit:
einem spezifizierten Abbildungsbereich (205), der dafür konfiguriert ist, eine Probe (203) für eine Strukturanalyse in einen Elektronenstrahl eines Elektronenmikroskops zu positionieren;
**gekennzeichnet durch**
eine optische Quelle (703, 801, 901, 105, 107, 113, 117), die dafür konfiguriert ist, Licht für eine optische Analyse auf die Probe (203) zu richten;
einen Manipulator (207), der dafür konfiguriert ist, eine Position der optischen Quelle (801, 901, 105, 107) bezüglich der Probe (203) zu steuern; und
einen optischen Eingang (701, 801, 901, 101, 103, 117), der dafür konfiguriert ist, Licht zu empfangen, das mit der Probe (203) in Wechselwirkung getreten ist,
wobei der Elektronenmikroskop-Probenhalter dafür konfiguriert ist, eine gleichzeitige Struktur- und optische Analyse der Probe bereitzustellen.

2. Halter nach Anspruch 1, ferner mit einer Sonde (201, 801, 901), die dafür konfiguriert ist, für eine gleichzeitige Struktur- und/oder mechanische Analyse mit der Probe (203) zu wechselwirken.

3. Halter nach Anspruch 1 oder 2, wobei die optische Quelle (703, 117) eine optische Faser ist.

4. Halter nach einem der Ansprüche 1 bis 3, wobei der Manipulator (207) dafür konfiguriert ist, die Position der optischen Quelle (801, 901, 105, 107) einzustellen.

5. Halter nach einem der Ansprüche 1 bis 3, wobei der Manipulator (207) dafür konfiguriert ist, die Position der Probe (203) einzustellen.

6. Halter nach einem der Ansprüche 1 bis 5, ferner mit einer zweiten optischen Quelle (105, 107).

7. Halter nach einem der Ansprüche 1 bis 5, der dafür konfiguriert ist, den Pfad eines optischen Strahls umzukehren (113), so dass Licht, das mit der Probe in Wechselwirkung getreten ist, entlang des gleichen optischen Pfades gerichtet wird, allerdings in eine Richtung, die dem zur Probe hin gerichteten Licht entgegengesetzt ist.

8. System (600) zum Analysieren von Materialeigenschaften einer Probe (203) in einem Elektronenmikroskop, mit:
einem Probenhalter (601) nach einem der vorangehenden Ansprüche;
einer Steuereinrichtung (608) zum Steuern des Probenhalters (601) und zum Erhalten von Messsignalen vom Probenhalter (601);
einer Lichtquelle (603), die dafür eingerichtet ist, Licht zum Probenhalter (601) hin zu richten, wobei die Lichtquelle (603) mit der optischen Quelle verbunden ist;
einem Lichtdetektor (605), der Licht vom Probenhalter (601) empfängt, wobei der Lichtdetektor (605) mit dem optischen Eingang (701, 801, 901, 101, 103, 117) verbunden ist; und
einer mit der Steuereinrichtung verbundenen Recheneinrichtung (607), die dafür konfiguriert ist, Signale vom Probenhalter (601) zu analysieren, und ferner dafür konfiguriert ist, der Steuereinrichtung Anweisungen zuzuführen.

9. Verfahren zum Analysieren von Materialeigenschaften einer Probe (203), wobei das Verfahren die Schritte aufweist.
Bereitstellen eines Elektronenmikroskop-Probenhalters (601, 700, 800, 900) nach Anspruch 1;
Positionieren einer Probe (203) in einen spezifizierten Abbildungsbereich (205) des Elektronenmikroskop-Probenhalters und in einen Elektronenstrahl eines Elektronenmikroskops für eine Strukturanalyse;
Richten von Licht von einer im Elektronenmikroskop-Probenhalter angeordneten optischen Quelle (703, 801, 901, 105, 107, 113, 117) auf die Probe (203) für eine optische Analyse;
Steuern einer Position der optischen Quelle (801, 901, 105, 107) bezüglich der Probe (203) auf dem Elektronenmikroskop-Probenhalter durch einen Manipulator (207);
Erfassen von Licht an einem optischen Eingang (701, 801, 901, 101, 103, 117) auf dem Elektronenmikroskop-Probenhalter nach einer Wechselwirkung mit der Probe (203); und
gleichzeitiges Erhalten von Bildern durch das Elektronenmikroskop.

10. Verfahren nach Anspruch 9, ferner mit dem Veranlassen einer Wechselwirkung einer Sonde (201, 801, 901) mit der Probe (203) und Erhalten eines Wechselwirkungsmessergebnisses.

11. Verfahren nach Anspruch 10, ferner mit dem zeitlichen Inbeziehungsetzen des erfassten Lichts mit den durch das Elektronenmikroskop erhaltenen Bildern und dem Wechselwirkungsmessergebnis.

## Revendications

1. Porte-échantillon (601) de microscope électronique comportant :
une zone de formation d'image désignée (205) configurée pour positionner un échantillon (203) dans un faisceau d'électrons d'un microscope électronique pour une caractérisation structurelle ;
**caractérisé par**
une source optique (703, 801, 901, 105, 107, 113, 117) configurée pour diriger une lumière sur l'échantillon (203) pour une caractérisation optique,
un manipulateur (207) configuré pour contrôler une position de la source optique (801, 901, 105, 107) par rapport à l'échantillon (203), et
une entrée optique (701, 801, 901, 101, 103, 117) configurée pour recevoir la lumière qui a interagi avec l'échantillon (203),
dans lequel le porte-échantillon pour microscope électronique est configuré pour assurer une caractérisation structurelle et optique simultanée de l'échantillon.

2. Porte-échantillon selon la revendication 1, comportant en outre une sonde (201, 801, 901) configurée pour interagir avec l'échantillon (203) pour une caractérisation structurelle et/ou mécanique simultanée.

3. Porte-échantillon selon la revendication 1 ou 2, dans lequel la source optique (703, 117) est une fibre optique.

4. Porte-échantillon selon l'une quelconque des revendications 1 à 3, dans lequel le manipulateur (207) est configuré pour régler la position de la source optique (801, 901, 105, 107).

5. Porte-échantillon selon l'une quelconque des revendications 1 à 3, dans lequel le manipulateur (207) est configuré pour régler la position de l'échantillon (203).

6. Porte-échantillon selon l'une quelconque des revendications 1 à 5, comportant en outre une seconde source optique (105, 107).

7. Porte-échantillon selon l'une quelconque des revendications 1 à 5, adapté de sorte qu'un trajet de faisceau optique est inversé (113) de sorte que la lumière qui a interagi avec l'échantillon est dirigée le long du même trajet de faisceau optique mais dans une direction opposée à la lumière dirigée vers l'échantillon.

8. Système (600) pour caractériser des propriétés matérielles d'un échantillon (203) dans un microscope électronique, comportant :
un agencement de porte-échantillon (601) selon l'une quelconque des revendications précédentes ;
un dispositif de contrôle (608) pour contrôler le porte-échantillon (601) et obtenir des signaux de mesure à partir du porte-échantillon (601) ;
une source lumineuse (603) agencée pour diriger la lumière vers le porte-échantillon (601), la source lumineuse (603) étant reliée à la source optique ;
un détecteur de lumière (605) recevant la lumière depuis le porte-échantillon (601), le détecteur de lumière (605) étant relié à l'entrée optique (701, 801, 901, 101, 103, 117) ; et
un dispositif de calcul (607) en communication avec le dispositif de contrôle configuré pour analyser les signaux provenant du porte-échantillon (601) et configuré en outre pour délivrer des instructions au dispositif de contrôle.

9. Procédé pour caractériser des propriétés matérielles d'un échantillon (203), le procédé comportant :
la fourniture d'un porte-échantillon pour microscope électronique (601, 700, 800, 900) selon la revendication 1,
le positionnement d'un échantillon (203) dans une zone de formation d'image désignée (205) du porte-échantillon pour microscope électronique et dans un faisceau électronique du microscope électronique pour une caractérisation structurelle ;
la propagation de la lumière à partir d'une source optique (703, 801, 901, 105, 107, 113, 117) comprise dans le porte-échantillon pour microscope électronique sur l'échantillon (203) pour une caractérisation optique ;
sur le porte-échantillon pour microscope électronique, le contrôle avec un manipulateur (207) d'une position de la source optique (801, 901, 105, 107) par rapport à l'échantillon (203),
la détection de la lumière à une entrée optique (701, 801, 901, 101, 103, 117) sur le porte-échantillon pour microscope électronique lors de l'interaction avec l'échantillon (203) ; et
l'obtention simultanée d'images avec le microscope électronique.

10. Procédé selon la revendication 9, comportant en outre l'interaction d'une sonde (201, 801, 901) avec l'échantillon (203) et l'obtention d'une mesure d'interaction.

11. Procédé selon la revendication 10, comportant en outre l'association de la lumière détectée avec les images obtenues grâce au microscope électronique et la mesure d'interaction avec une autre dans le temps.
